# EUROPÄISCHE PATENTSCHRIFT

(11) **EP 1 495 153 B1**
(45) Veröffentlichungstag und Bekanntmachung des Hinweises auf die Patenterteilung: **15.10.2008**
(21) Anmeldenummer: 03737955.9
(22) Anmeldetag: 15.04.2003
(51) Int. Cl.: C23C 14/10

(54) **VERFAHREN ZUR BESCHICHTUNG VON METALLOBERFLÄCHEN**
METHOD FOR COATING METAL SURFACES
PROCEDE POUR REVETIR DES SURFACES METALLIQUES

(30) Priorität: 15.04.2002 DE 20205830 U; 23.05.2002 DE 10222958; 23.05.2002 DE 10222964; 23.05.2002 DE 10222609; 13.11.2002 DE 10252787; 16.01.2003 DE 10301559
(43) Veröffentlichungstag der Anmeldung: 12.01.2005
(73) Patentinhaber: Schott AG, 55122 Mainz (DE)
(72) Erfinder: MUND, Dietrich, 84101 Obersüssbach (DE); LEIB, Jürgen, 85354 Freising (DE)
(74) Vertreter: Blumbach - Zinngrebe
(86) Internationale Anmeldenummer: PCT/EP2003/003872
(87) Internationale Veröffentlichungsnummer: WO 2003/087423

(56) Entgegenhaltungen:
- CH-A- 387 175
- US-A- 4 104 418
- US-A- 4 737 252
- KATO K ET AL: "SPUTTERED LEAD SILICATE GLASS FILM FOR MULTILEVEL INTERCONNECTIONS" JAPANESE JOURNAL OF APPLIED PHYSICS, PUBLICATION OFFICE JAPANESE JOURNAL OF APPLIED PHYSICS. TOKYO, JP, Bd. 22, Nr. SUPPL 22-1, 1983, Seiten 167-170, XP000819426 ISSN: 0021-4922
- ANONYMOUS: "Eliminating the Step in Etched Via Holes Interrupted Sputter Glass Deposition. December 1977." IBM TECHNICAL DISCLOSURE BULLETIN, Bd. 20, Nr. 7, 1. Dezember 1977 (1977-12-01), Seite 2667 XP002251599 New York, US

## Beschreibung

Die Erfindung betrifft allgemein ein Verfahren gemäß den Anspruch 1 zur Beschichtung von Metalloberflächen mit glasartigen Schichten.

Glasartige Beschichtungen haben unter anderem sehr gute Passivierungs- und Verkapselungseigenschaften. So bieten Gläser einen hervorragenden Schutz gegen Wasser, Wasserdampf und insbesondere auch gegen aggressive Stoffe, wie Säuren und Basen.

Glasartige Schichten zum Schutz von metallischen Oberflächen sind seit langem als Emaille bekannt. Beim Emaillieren wird ein anorganisches, lösungsmittelfreies Glasgemisch auf dem Metallsubstrat aufgetragen und anschließend aufgeschmolzen.

Mit einem derartigen Verfahren lassen sich jedoch keine dünnen Glasschichten oder Glasschichten genau definierter Dicke auf metallischen Substraten abscheiden. Zudem ist ein solches Verfahren, welches eine Vorbeschichtung wieder aufschmelzt, nur für Substrate geeignet, die eine hinreichende Temperaturbeständigkeit aufweisen. Überdies ist es damit auch nicht möglich, eine genau strukturierte glasartige Schicht auf einem Substrat zu erzeugen.

Der Erfindung liegt daher die Aufgabe zugrunde, ein hinsichtlich der oben genannten Nachteile verbessertes Herstellungsverfahren für solche beschichtete Substrate mit metallischer Fläche und glasartiger Beschichtung.

Diese Aufgabe wird bereits in höchst überraschend einfacher Weise durch den Gegenstand des unabhängigen Anspruchs gelöst. Vorteilhafte Weiterbildungen und Ausgestaltungen sind in den jeweiligen Unteransprüchen angegeben.

Dementsprechend sieht die Erfindung ein Verfahren zur Herstellung eines beschichteten Substrats, ein Aufdampfglas strucktusiert auf der metallischen Fläche obgeschiden und das Substrak zumindest aust der metallischen fläche mit dem Aufdampfglas beschichket wird, dadurch gekennzeichnet, dass das Autdampfglas durch Elektrunen strahverdampfung aufgedampft wird. welches zumindest eine metallische Fläche aufweist, wobei

Die Aufdampfglasschicht eines durch das erfindungsgemäße Verfahren erhaltenen Erzeugnisses kann dabei als Passivierungs- oder Verkapselungsschicht dienen. Außerdem zeichnen sich Aufdampfgläser auch durch sehr gute elektrische Isolationseigenschaften aus.

Bezüglich der Barriereeigenschaften von Aufdampfglas für die Verkapselung von Bauelementen und anderen Substraten wird auch auf die Anmeldungen
DE 202 05 830.1, eingereicht am 15.04.2002,
DE 102 22 964.3, eingereicht am 23.05.2002;
DE 102 22 609.1, eingereicht am 23.05.2002;
DE 102 22 958.9, eingereicht am 23.05.2002;
DE 102 52 787.3, eingereicht am 13.11.2002;
DE 103 01 559.0, eingereicht am 16.01.2003; desselben Anmelders verwiesen.

Hinsichtlich der Barriereeigenschaften von Aufdampfglasschichten haben Messungen gezeigt, daß bei Schichtdicken der Aufdampfglasschicht im Bereich von 8 µm bis 18 µm Helium-Leckraten von kleiner als 10⁻⁷ mbar 1 s⁻¹ oder kleiner als 10⁻⁸ mbar 1 s⁻¹ sicher erreicht werden. Die Messungen haben bei Schichten mit einer Schichtdicke von 8 µm und 18 µm sogar Helium-Leckraten zwischen 0 bis 2x10⁻⁹ mbar 1 s⁻¹ ergeben, wobei diese oberen Grenzwerte bereits im wesentlichen durch die Meßungenauigkeit der durchgeführten Versuche beeinflußt sind.

Als Substrat mit metallischer Fläche können dabei sowohl massiv metallische Substrate, als auch Substrate verwendet werden, die nur teilweise metallisch sind, wie zum Beispiel geeignete Verbundmaterialien . Ein Beispiel eines derartigen Substrats ist ein kupferbeschichtetes Kunststoffsubstrat, wie es für Leiterplatten Anwendung findet.

Aufgrund der erfindunsgemäßen Beschichtung bei niedrigen oder mäßigen Temperaturen ermöglicht es die Erfindung außerdem, Erzeugnisse mit glasbeschichteter metallischer Fläche bereitzustellen, bei welche das Metall auch einen Schmelzpunkt haben kann, der unterhalb der üblicherweise zum Emaillieren eingesetzten Temperaturen liegt. Dementsprechend kann das Verfahren auch beispielsweise auf Substrate mit niedrigschmelzenden Legierungen Anwendung finden und erlaubt so auch neue Materialkombinationen in erfindungsgemäß herstellbaren Erzeugnissen.

Für die Durchführung des erfindungsgemäßen Verfahrens ist es auch nicht zwingend erforderlich, daß das Substrat oder die zu beschichtende metallische Fläche planar ist. Vielmehr kann eine Beschichtung mit einer Aufdampfglasschicht auch problemlos auf gewölbte und/oder gestufte Metallflächen aufgebracht werden. Dementsprechend kann mit dem erfindungsgemäßen Verfahren ein Erzeugnis, beziehungsweise ein beschichtetes Substrat hergestellt werden, dessen beschichtete metallische Fläche nicht planar ist.

Um derartige nicht planare Flächen zu beschichten, oder um beispielsweise homogene Beschichtungen auf großflächigen Substraten zu erzeugen, kann es außerdem vorteilhaft sein, wenn das Substrat während des Beschichtens gegenüber der Beschichtungsquelle bewegt wird. Diese Bewegung kann unter anderem eine Rotation, Translation oder Nutation oder auch eine Kombination dieser Bewegungen umfassen.

Gemäß der Erfindung wird das Glas durch Elektronenstrahlverdampfung abgeschieden, wobei das Glasmaterial aus einer geeigneten Quelle verdampft wird.

Ein Vorteil beim Aufdampfen ist, daß das zu beschichtende Substrat keiner hohen Temperaturbelastung ausgesetzt werden muß. Das Substrat kann beim Abscheiden in einem Temperaturbereich zwischen Raumtemperatur und etwa 150 °C gehalten werden. In diesem Temperaturbereich tritt im allgemeinen keinerlei Schädigung oder Oxidation des Substrats auf.

Unter einem Aufdampfglas wird im Sinne dieser Erfindung ein Glas mit zumindest binärem Stoffsystem verstanden, das durch Aufdampfen auf einer Oberfläche abgeschieden werden kann. Als Aufdampfglas kann unter anderem ein Borosilikatglas mit Anteilen von Aluminiumoxid und Alkalioxid verwendet werden, wie es die Aufdampfgläser vom Typ 8329 oder G018-189 der Firma Schott Glas darstellen. Dieses Glas hat außerdem einen Wärmeausdehnungskoeffizienten, der dem von üblichen metallischen Substraten nahekommt, beziehungsweise durch entsprechende Abwandlung in den Komponenten an den Wärmeausdehnungskoeffizienten des Substrats angepaßt werden kann.

Es kann auch Aufdampfglas anderer Zusammensetzung verwendet werden, insbesondere in mehreren Schichten übereinander, wobei die Gläser unterschiedliche Eigenschaften hinsichtlich Brechungsindex, Dichte, Härte usw. besitzen können.

Als besonders geeignete Aufdampfgläser für ein erfindungsgemäßes beschichtetes Substrat, beziehungsweise ein erfindungsgemäßes Erzeugnis haben sich zwei Gläser erwiesen, die folgende Zusammensetzung in Gewichtsprozent aufweisen:

| Komponenten: | Glas1 | Glas2 |
|---|---|---|
| SiO₂ | 75 -85% | 65-75% |
| B₂O₃ | 10- 15% | 20-30% |
| Na₂O | 1-5% | 0,1-1% |
| Li₂O | 0,1-1% | 0,1-1% |
| K₂O | 0,1-1% | 0,5-5% |
| Al₂O₃ | 1-5% | 0,5-5% |

Die bevorzugt verwendeten Gläser besitzen insbesondere die in der nachstehenden Tabelle aufgeführten Eigenschaften:

| Eigenschaften | Glas1 | Glas2 |
|---|---|---|
| α₂₀₋₃₀₀ [10⁻⁶K⁻¹] | 2,7 5 | 3,2 |
| Dichte (g/cm³) | 2,201 | 2,12 |
| Transformationspunkt [°C] | 562 °C | 742 |
| Brechungsindex | n_{D}=1,469 | 1,465 |
| Wasserbeständigkeitklasse nach ISO 719 | 1 | 2 |
| Säurebeständigkeitsklasse nach DIN 12 116 | 1 | 2 |
| Laugenbeständigkeitsklasse nach ISO 695 | 2 | 3 |
| Dielektrizitätskonstante ε (25 °C) | 4,7 (1MHz) | 3,9 (40GHz) |
| tanδ (25 °C) | 45*10⁻⁴ (1MHz) | 26*10⁻⁴ (40GHz) |

Aufdampfglas läßt sich neben dem Aufdampfen aber auch durch verschiedene andere Vakuumbeschichtungsverfahren auf dem Substrat abscheiden. Beispielsweise kann das Material durch Kathodenzerstäubung oder Sputtern abgeschieden werden, diese methoden sind jedoch nicht erfindungsgemäß.

Sowohl Kato et al. Japanese Journal of Applied Physics, vol.22 (1983) suppl. no.22-1 p.167-170, als Bialko et al. IBM Technical Disclosure Bulletin, vol.20(7) (1977) p.267 offenbaren Verfahren, wobei eine strukturierte Glasschicht mittels Sputtern auf eine Metallfläche erzeugt wird.

Das Abscheiden der Glasschicht durch Aufdampfen hat gegenüber anderen Vakuum-Abscheideverfahren den Vorzug, daß sich wesentlich höhere Abscheide- oder Aufdampfraten erzielen lassen. Versuche haben gezeigt, daß Aufdampfraten von mehr als 4 µm Schichtdicke pro Minute erreicht werden können, wobei das hergestellte Glas sich mit festem Verbund auf der Oberfläche des Substrats abscheidet, ohne daß es eines erhöhten H₂O-Gehalt zwecks Bindungswirkung bedarf wie bei Niedrig - Temperatur-Bondverfahren (LTB).

Die durch Aufdampfen erreichbaren Abscheideraten übertreffen die Abscheideraten anderer Verfahren um.ein Vielfaches. So werden beispielsweise bei Einkomponentensystemen, wie Siliziumoxid nur Sputterraten von wenigen Nanometern pro Minute erreicht.

Bei der Beschichtung mit dem Aufdampfglas durch Aufdampfen wird das Material durch Elektronenstrahlverdampfung verdampft und abgeschieden. Vorteilhaft bei der Elektronenstrahlverdampfung ist unter anderem, daß die durch den Elektronenstrahl übertragene Leistung auf einem verhältnismäßig kleinen Gebiet durch Fokussierung des Strahls konzentrieren lassen. Damit können lokal auf dem Target des Verdampfers hohe Temperaturen erreicht werden, so daß sich hohe Flüsse mit relativ kleinen Leistungen erreichen lassen. Dies senkt gleichzeitig auch die Wärmebelastung durch Absorption von Wärmestrahlung, der das Substrat ausgesetzt wird.

Mit dem erfindungsgemäßen Verfahren wird das Aufdampfglas strukturiert auf der metallischen Fläche abgeschieden, so daß das Substrat nach Fertigstellung eine strukturierte Aufdampfglas-Schicht aufweist. Dabei kann sowohl eine laterale, als auch eine vertikale Strukturierung der Beschichtung hergestellt werden.

Das Herstellen strukturierter Glasschichten wird außerdem in den früheren deutschen Patentanmeldungen mit den Anmeldenummmern 102 22 609.1 und 102 22 964.3 beschrieben.

Um insbesondere laterale Strukturen auf der metallischen Fläche des Substrats zu erzeugen, sieht die Erfindung eine Ausgestaltung des erfindungsgemäßen Verfahrens mit den Schritten vor:
- Herstellen zumindest einer negativ strukturierten ersten Beschichtung auf der metallischen Fläche,
- Abscheiden einer Aufdampfglasschicht auf die mit der ersten Beschichtung versehene metallischen Fläche,
- zumindest teilweise Entfernen der ersten Beschichtung und der darauf befindlichen Aufdampfglasschicht.

Das Verfahren basiert also darauf, eine Negativform der Strukturen, die erzeugt werden sollen, in Form einer strukturierten ersten Beschichtung aufzubringen. Durch Abscheiden der Aufdampfglasschicht auf der mit der ersten, strukturierten Schicht beschichteten Fläche des Substrats werden dann die positiven Strukturen in der zweiten Schicht erzeugt. In einem nachfolgenden Schritt wird dann die erste Beschichtung und die darauf befindliche Aufdampfglasschicht zumindest teilweise entfernt, so dass positive Aufdampfglas-Strukturen stehen bleiben. Als positive und negative Strukturen werden dabei im Sinne des angegebenen Verfahrens allgemein zueinander zumindest teilweise komplementäre Strukturen bezeichnet. Dies bedeutet auch insbesondere, daß die zumindest eine zweite Beschichtung sowohl erhabene, als auch vertiefte Strukturen aufweisen kann.

Besonders vorteilhaft kann der Schritt des Herstellens einer negativ strukturierten ersten Beschichtung auf der metallischen Fläche des Substrats den Schritt des Freilegens von Bereichen der zumindest einen zu beschichtenden Oberfläche umfassen. Auf diese Weise kommt die Aufdampfglasschicht beim Abscheiden direkt mit der zu beschichtenden Oberfläche des Substrats in Kontakt und zwischen der Oberfläche und der Schicht wird eine innige, direkte Verbindung geschaffen.

Der Schritt des Herstellens einer negativ strukturierten ersten Beschichtung kann ferner vorteilhaft den Schritt des Belackens, insbesondere des Belackens mittel Spin-Coating und/oder Bedrucken und/oder Aufsprühen und/oder der Elektrodeposition einer ersten Beschichtung umfassen. Diese Techniken erlauben unter anderem die Herstellung von Beschichtungen mit homogener Dicke. Die-Belackung kann zur Herstellung besonderer Strukturierungen außerdem auch in mehreren Schritten erfolgen.

Eine vorteilhafte Weiterbildung des erfindungsgemäßen Verfahrens sieht vor, daß der Schritt des Herstellens einer negativ strukturierten ersten Beschichtung den Schritt des lithographischen Strukturierens der ersten Beschichtung umfaßt. Lithographische Strukturierung wird in vielfältiger Weise beispielsweise auch in der Halbleiterfertigung eingesetzt. Mit dieser Strukturierungstechnik lassen sich hohe Genauigkeiten der Strukturen bei gleichzeitig hohem Durchsatz erreichen. Dieses Verfahren kann unter anderem auch mit Druckverfahren wie Siebdruck oder Tintenstrahldruck kombiniert werden. So lassen sich gröbere Strukturen, wie etwa die Umrisse der Bauteile auf einem Wafer durch Aufdrucken eines Photolacks strukturieren und die Feinstruktur dann lithographisch erzeugen. Diese Weiterbildung des erfindungsgemäßen Verfahrens vereint demgemäß die Vorteile der Photolithographie mit denen der Glasstrukturierung.

Zur Herstellung der positiv strukturierten Aufdampfglasschicht kann der Schritt des zumindest teilweise Entfernens der ersten Beschichtung vorteilhaft den Schritt des Abhebens von Bereichen der Aufdampfglasschicht umfassen, welche die erste Beschichtung bedecken. Dabei werden die Bereiche der Aufdampfglasschicht, welche die erste Beschichtung bedecken, durch das Entfernen der ersten Beschichtung unter der Aufdampfglasschicht abgehoben und so entfernt. Diese Technik des Strukturierens von Beschichtungen wird vielfach auch als "Lift-off"-Verfahren bezeichnet.

In einfacher Weise läßt sich dieses Verfahren insbesondere dann durchführen, wenn die Aufdampfglasschicht mit einer Dicke abgeschieden wird, die geringer als die Dicke der ersten Beschichtung ist. Auf diese Weise bleibt die erste Beschichtung an den Seitenkanten der Strukturen der Beschichtung auch nach dem Abscheiden der Aufdampfglasschicht zugänglich und kann anschließend leicht, beispielsweise durch Auflösen mit einem geeigneten Lösungsmittel wieder entfernt werden, wobei die Bereiche der Aufdampfglasschicht, welche die Strukturen der ersten Beschichtung bedecken, mit angehoben werden.

Eine weitere Variante des Verfahrens sieht als zusätzlichen Verfahrensschritt das zumindest teilweise Freilegen der ersten Beschichtung vor, so dass diese erste Schicht nicht mehr hermetisch von der zweiten Schicht abgedeckt wird. Auf diese Weise wird ein äußerer Zugriff auf die erste Beschichtung ermöglicht.

Um für das nachfolgende Entfernen der ersten Beschichtung einen Zugang zu schaffen, ist es von Vorteil, wenn der Schritt des zumindest teilweisen Freilegens der ersten Beschichtung den Schritt des Planarisierens der beschichteten metallischen Fläche umfaßt. Dabei wird die beschichtete Oberfläche des Substrats so weit planarisiert, bis die Aufdampfglasschicht an den Stellen, an welchen sich Strukturen der ersten, strukturierten Beschichtung befinden, entfernt ist.

Das teilweise Abtragen der Aufdampfglasschicht kann zweckmäßig durch mechanisches Abtragen, insbesondere mittels Schleifen und/oder Läppen und/oder Polieren erfolgen.

Das Verfahren kann zusätzlich noch den Schritt des Nachbehandelns der positiv strukturierten zweiten Schicht umfassen. Das Nachbehandeln kann beispielsweise dazu dienen, Kanten der Strukturen zu verrunden. Geeignete Nachbehandlungsschritte sind dabei insbesondere nasschemischer und/oder trockenchemischer und/oder thermischer Reflow. Auch durch Dotierung können die Strukturen nachbehandelt werden, um beispielsweise optische oder elektrische Eigenschaften der Strukturen zu verändern.

Eine weitere Ausführungsform des erfindungsgemäßen Verfahrens, mit welchem in besonders einfacher Weise eine lateral strukturierte Aufdampfglasschicht auf der metallischen Fläche hergestellt werden kann, sieht vor, daß das Aufdampfglas durch eine Maske aufgedampft wird.

Die Maske kann dazu gemäß einer Variante des Verfahrens fest mit dem Substrat aufgebracht, beispielsweise aufgeklebt sein. Gemäß einer weiteren Variante wird die Maske zwischen der Beschichtungsquelle und dem Substrat angeordnet.

Eine weitere Ausgestaltung des erfindungsgemäßen Verfahrens sieht zur Erzeugung einer strukturierten Aufdampfglasschicht vor, die Aufdampfglasschicht nach dem Beschichten nachträglich zu strukturieren. Dies kann in einfacher Weise durch Strukturierung mittels lokalem Ätzen nach dem Beschichten erfolgen.

Das lokale Ätzen kann beispielsweise durch photolithographische Strukturierung einer auf die Aufdampfglasschicht aufgebrachten photostrukturierbaren Beschichtung und anschließender Anwendung eines geeigneten Ätzmittels durch Nass- und/oder Trockenätzen erfolgen. Dabei kann das Ätzmittel vorteilhaft auch so gewählt werden, daß die Metallfläche als Ätzstopp wirkt.

Mit dem erfindungsgemäßen Verfahren lassen sich nicht nur einfache strukturierte oder gleichmäßige Aufdampfglasschichten abscheiden. Es liegt selbstverständlich auch im Rahmen der Erfindung, zumindest zwei Aufdampfglasschichten auf dem Substrat abzuscheiden. Diese müssen auch nicht die gleiche Zusammensetzung aufweisen, so daß durch das nacheinander Aufbringen der Schichten auch eine vertikale Strukturierung der Beschichtung hergestellt werden kann. Ein auf diese Weise herstellbares beschichtetes Substrat umfaßt demgemäß eine mehrlagige Beschichtung mit zumindest zwei Aufdampfglasschichten, wobei diese auch unterschiedliche Zusammensetzungen aufweisen können.

Die Aufdampfglasschicht kann vorzugsweise mit einer Dicke in einem Bereich von 0.01 µm bis 1mm auf das Substrat aufgebracht werden.

Gemäß einer vorteilhaften Weiterbildung kann während des Aufbringens der Aufdampfglasschicht dessen Zusammensetzung variiert werden, so daß demgemäß ein beschichtetes Substrat mit einer Aufdampfglasschicht mit einer in Richtung senkrecht zur beschichteten Fläche variierenden Zusammensetzung erhalten wird. Beispielsweise kann damit der Temperaturausdehnungskoeffizient entlang der Richtung senkrecht zur Substratoberfläche variiert werden. Auf diese Weise können auch Aufdampfgläser und metallische Substrate aufeinander angepaßt werden, die stärker voneinander abweichende Temperaturausdehnungskoeffizienten aufweisen.

Eine weitere Ausführungsform der Erfindung sieht vor, daß das Beschichten mit einer Aufdampfglasschicht das Abscheiden von Aufdampfmaterial aus zumindest zwei Quellen durch Coverdampfung umfaßt. Auch diese Weiterbildung des Verfahrens ist beispielsweise geeignet, variierende Zusammensetzungen in der Schicht zu erzeugen, so daß Materialeigenschaften, wie beispielsweise der Brechungsindex oder auch der Temperaturkoeffizient in Richtung senkrecht zur Oberfläche kontinuierlich oder auch abgestuft variieren.

Eine Variation der Zusammensetzung der Schicht ist selbstverständlich auch mit anderen Abscheideverfahren, sogar mit einer einzelnen Aufdampfquelle, zum Beispiel durch Variation der Heizleistung möglich. Der Schritt des Abscheidens einer Aufdampfglasschicht kann daher allgemein mit Vorteil den Schritt des Variierens der Zusammensetzung des abscheidenden Materials während des Abscheidens, oder den Schritt des Abscheidens einer Schicht mit entlang einer Richtung senkrecht zur Oberfläche variierender Zusammensetzung umfassen.

Das Coverdampfen kann beispielsweise so erfolgen, daß zwei oder mehr Komponenten des Aufdampfglases aus verschiedenen Quellen verdampft werden, welche dann abgeschieden auf der Oberfläche des Substrats das Aufdampfglas bilden. Ebenso ist es aber auch möglich, das Aufdampfglas aus einer einzelnen Quelle abzuscheiden und mit einer weiteren Quelle Zusatzstoffe in die Aufdampfglasschicht einzubringen.

Eine Variation der Zusammensetzung der Schicht ist selbstverständlich auch mit anderen Abscheideverfahren, sogar mit einer einzelnen Aufdampfquelle, möglich, etwa, indem die Heizleistung oder die Abscheiderate variiert wird.

Vorteilhaft zum Erreichen geschlossener, hermetisch dichter Aufdampfglasschichten ist es ferner, wenn die Oberflächenrauhigkeit der beschichteten metallischen Fläche kleiner oder gleich 50 µm beträgt.

Auch ist bei vielen zu beschichteten metallischen Substratmaterialien eine leichte Erwärmung des Substrats während des Beschichtens mit der Aufdampfglasschicht, beispielsweise auf etwa 100 °C vorteilhaft, um Temperaturspannungen nach dem Abkühlen zu reduzieren.

Auch ist es zur Erzielung dichter Aufdampfglasschichten mit geringen Verunreinigungen günstig, wenn der Druck während des Beschichtens in der Beschichtungskammer höchstens 10⁻⁴ mbar, vorteilhafterweise 10⁻⁵ mbar beträgt.

Vorteilhaft kann das Beschichten des Substrats mit einer Aufdampfglasschicht auch das Plasma-Ionen-unterstützte Aufdampfen (PIAD) umfassen. Dabei wird zusätzlich ein Ionenstrahl auf das zu beschichtende Substrat gerichtet. Der Ionenstrahl kann mittels einer Plasmaquelle, beispielsweise durch Ionisation eines geeigneten Gases erzeugt werden. Durch das Plasma erfolgt eine zusätzliche Verdichtung der Schicht sowie die Ablösung lose haftender Partikel auf der Substratoberfläche Dies führt zu besonders dichten und defektarmen abgeschiedenen Schichten.

Im folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsformen miteinander kombiniert werden können.

Es zeigen:
- Fig. 1A: anhand schematischer Querschnittansichten
- bis 1E: Verfahrensschritte zur strukturierten Beschichtung von Substraten gemäß einer Ausführungsform des erfindungsgemäßen Verfahrens,
- Fig. 2A und 2B: eine Variante der anhand Fig. 1C bis 1E dargestellten Verfahrensschritte,
- Fig. 3A bis 3F: anhand schematischer Querschnittansichten Verfahrensschritte gemäß einer Ausführungsform der Erfindung zur mehrlagigen strukturierten Beschichtung eines Substrats,
- Fig. 4: eine schematische Ansicht einer Vorrichtung zur Durchführung des erfindungsgemäßen Verfahrens,
- Fig. 5: eine Querschnittansicht eines erfindungsgemäßen beschichteten Substrats mit vertikal variierender Zusammensetzung der Aufdampfglasschicht,
- Fig. 6: eine Anordnung zur Durchführung einer weiteren Ausführungsform eines erfindungsgemäßen Verfahrens zur strukturierten Beschichtung mit einer Aufdampfglasschicht,
- Fig. 7A bis 7D: Verfahrensschritte gemäß noch einer Ausführungsform zur Herstellung einer strukturierten Aufdampfglasschicht, und
- Fig. 8: eine Ausführungsform eines erfindungsgemäßen Erzeugnisses mit einem Substrat mit beschichteter metallischer Fläche.

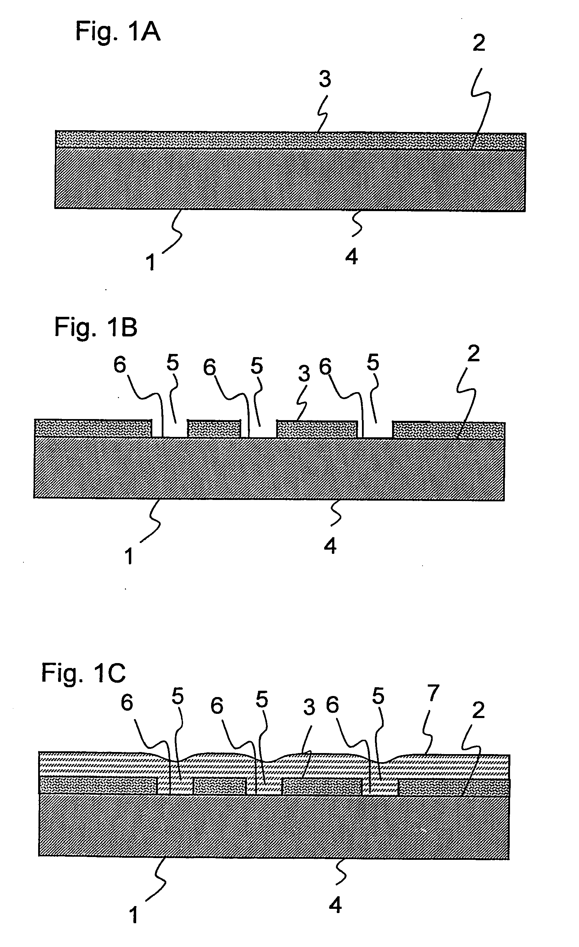

Im folgenden wird zunächst Bezug auf die Figuren 1A bis 1E genommen, welche anhand schematischer Querschnittansichten die Verfahrensschritte zur Herstellung eines beschichteten Substrats mit einer mit einem Glas beschichteten metallischen Fläche gemäß einer ersten Ausführungsform der Erfindung darstellen.

Das Substrat 1 weist zwei gegenüberliegende Flächen 2 und 4 auf, wobei zumindest das Material der zu beschichtenden Fläche 2 metallisch ist. Das Substrat 1 kann beispielsweise ein massiver metallischer Körper oder auch beispielsweise ein Verbundmaterial mit einer metallischen Lage sein, dessen Oberfläche die Fläche 2 bildet.

Zur Herstellung einer strukturierten Aufdampfglas-Beschichtung wird auf das Substrat 1, wie in Fig. 1A gezeigt, zunächst auf der zu beschichtenden Fläche 2 eine erste Beschichtung 3 aufgebracht.

Fig. 1B zeigt eine Querschnittansicht durch das Substrat 1 nach einem weiteren Verfahrensschritt. Hierbei wurden in die erste Beschichtung Strukturen 5 eingefügt. Diese Strukturen 5 schaffen eine zur endgültigen strukturierten Beschichtung komplementäre, negative Strukturierung. Die Strukturierung ist dabei so durchgeführt worden, daß Bereiche 6 der zu beschichtenden metallischen Fläche 2 des Substrats 1 freigelegt worden sind.

Die Strukturierung kann unter anderem photolithographisch erfolgen, wobei dazu die erste Beschichtung 3 beispielsweise einen Photolack umfaßt, in den anschließend durch Belichtung und Entwicklung die Strukturen 5 eingefügt worden sind.

Gemäß einer weiteren Variante des Verfahrens wird die Beschichtung 3 nicht nach dem Aufbringen strukturiert, sondern direkt beim Aufbringen der Schicht. Dies kann erreicht werden, indem die Schicht beispielsweise mittels eines geeignete Druckverfahrens, etwa mittels Siebdruck auf das Substrat 1 aufgedruckt wird. Bei dieser Variante des Verfahrens wird der in Fig. 1A gezeigte Verarbeitungszustand des Substrats 1 übersprungen. Selbstverständlich kann diese Variante aber auch mit einer nachträglichen Strukturierung kombiniert werden, indem zum Beispiel ein Photolack strukturierte auf die Oberfläche 2 des Substrats 1 aufgedruckt wird und die aufgedruckten Strukturen dann nachfolgend weiter strukturiert werden, etwa um zusätzliche, feinere Strukturen zu erzeugen. Mit dem anhand von Fig. 1B gezeigten Zustand des Substrates ist der Schritt des Herstellens einer negativ strukturierten Beschichtung abgeschlossen.

In Fig. 1C ist das Substrat nach dem Schritt des Beschichtens mit einer Aufdampfglasschicht 7 auf die mit der ersten Beschichtung 3 versehene Oberfläche 2 des Substrats 1 gezeigt. Das Beschichten erfolgt bevorzugt durch Elektronenstrahlverdampfung. Die Aufdampfglasschicht 7 bedeckt dabei die freigelegten Bereiche 6, sowie die erste Beschichtung 3.

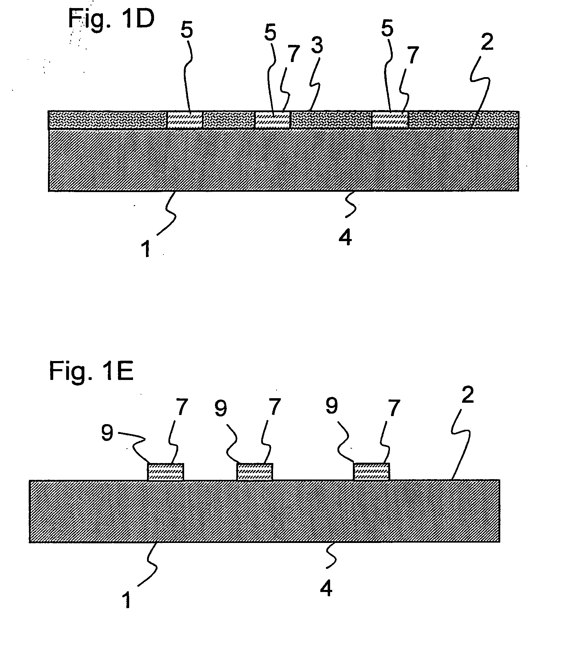

Fig. 1D zeigt das Substrat nach dem nachfolgenden Schritt des Freilegens der ersten Beschichtung 3. Das Freilegen der Beschichtung wurde in dieser Variante des Verfahrens durch Planarisieren der beschichteten metallischen Fläche 2 vorgenommen. Dazu wurde die beschichtete Oberfläche soweit plan abgeschliffen, bis die Schicht 7 auf der ersten Beschichtung abgetragen ist. Dadurch wurde die darunterliegende erste Beschichtung wieder freigelegt.

Fig. 1E zeigt einen darauffolgenden Verfahrensschritt, bei welchem die erste Beschichtung entfernt worden ist. Durch das Aufdampfen der Aufdampfglasschicht 7 auf die negativ strukturierte erste Beschichtung 3 und das Entfernen der ersten Beschichtung 3 nach deren Freilegung bleibt auf dem Substrat schließlich eine positiv strukturierte Aufdampfglasschicht 7 zurück. Die Strukturen 9 der positiv strukturierten Schicht 7 bedecken dabei die freigelegten, beziehungsweise von der ersten Beschichtung 3 nicht bedeckten Bereiche 6.

Das Entfernen der ersten, negativ strukturierten Beschichtung kann beispielsweise durch Auflösen in einem geeigneten Lösungsmittel oder durch nass- oder trockenchemisches Ätzen erfolgen. Auch eine Verbrennung oder Oxidation in einem Sauerstoffplasma kann vorteilhaft für die Entfernung der Beschichtung angewendet werden.

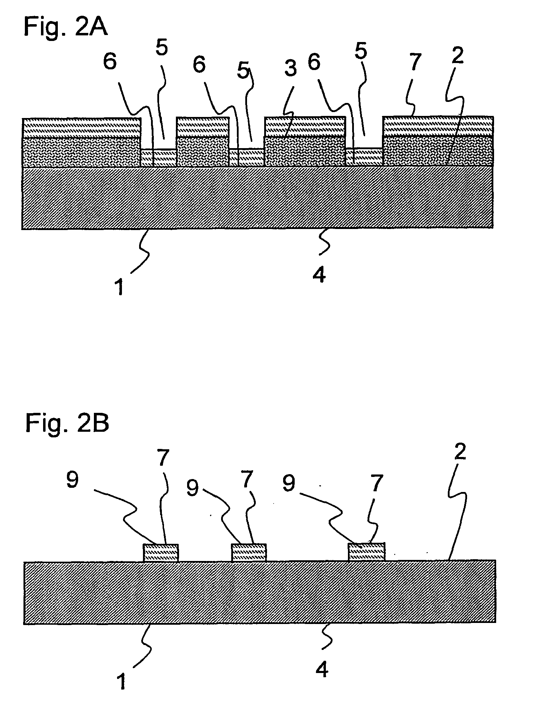

Anhand der Figuren 2A und 2B wird im folgenden eine bevorzugte Variante der anhand der Figuren 1C und 1E gezeigten Verfahrensschritte erläutert. Bei dieser Variante des Verfahrens wird zunächst das Substrat 1 wie anhand der Figuren 1A und 1B gezeigt wurde, durch Aufbringen einer strukturierten ersten Beschichtung 3 vorbereitet. Die Beschichtung 3 weist wieder negative Strukturen 5 auf, welche Bereiche 6 der ersten Oberfläche 2 freilassen. Auf die so vorbereitete Oberfläche des Substrats wird wieder eine Aufdampfglasschicht 7, beispielsweise durch Elektronenstrahlverdampfung von einem Glastarget Aufdampfglases. Die Schichtdicke der Schicht 7 wird hierbei allerdings so gewählt, daß die Schicht 7 nicht geschlossen ist. Dies wird erfindungsgemäß dadurch erreicht, indem die Dicke der Aufdampfglasschicht 7 geringer ist als die Dicke der ersten Beschichtung. Diese Phase des Verfahrens ist in Fig. 2A gezeigt.

Die erste Beschichtung 3 kann dann direkt entfernt werden, ohne daß ein Freilegen, etwa durch das anhand von Fig. 1C gezeigte Planarisieren erforderlich ist, da durch die nicht geschlossene Aufdampfglasschicht 7 ein Zugang zur ersten Beschichtung 3 an den Seitenkanten der Strukturen erhalten bleibt. Die Bereiche der Schicht 7, welche sich dabei auf der ersten Beschichtung 3 befinden, werden beim Entfernen der ersten Beschichtung 3 abgehoben und dadurch entfernt.

Als Ergebnis bleibt, wie Fig. 2B zeigt, wieder eine strukturierte Aufdampfglasschicht 7 mit positiven Strukturen 9 zurück.

Auf die Strukturen 9 der strukturierten zweiten Schicht 7 der in Fig. 1E oder 2B gezeigten Ausführungsformen kann in einem zusätzlichen Schritt auch noch eine Bond-Schicht aufgebracht werden, welche die der Substratoberfläche abgewandten Oberseiten der Strukturen 9 bedeckt. Eine solche Bond-Schicht kann beispielsweise eine Seed-Schicht für eine nachfolgende Metallisierung oder etwa eine Klebstoffschicht umfassen.

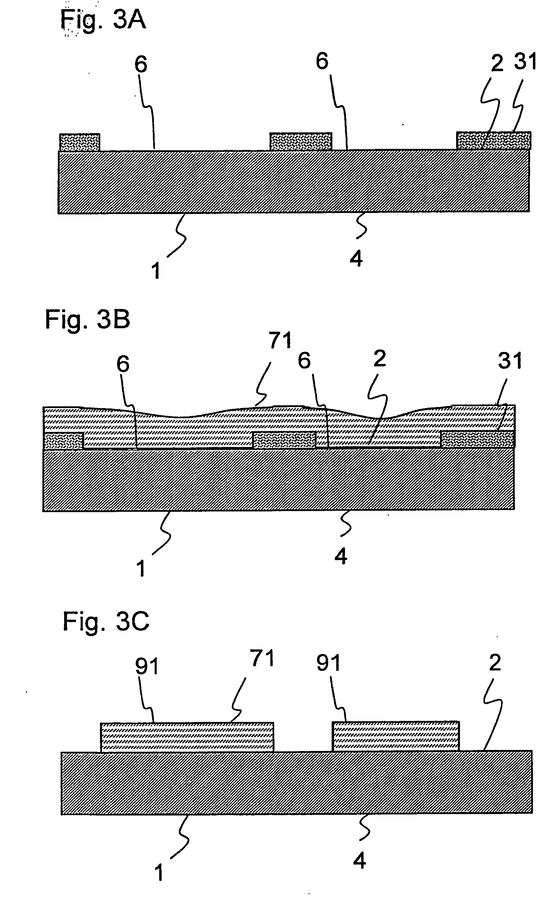

Die Figuren 3A bis 3F zeigen eine weitere Ausführungsform des erfindungsgemäßen Verfahrens, wobei diese Ausführungsform zur Herstellung mehrlagiger strukturierter Aufdampfglasschichten dient.

Zum Zwecke der Übersichtlichkeit sind in den Figuren 3A bis 3F dabei einige der anhand der Figuren 1A bis 1E, beziehungsweise 2A und 2B erläuterten Verfahrensschritte nicht im einzelnen dargestellt.

Fig. 3A zeigt ein Substrat 1, auf welchem eine strukturierte erste Beschichtung 31 auf der metallischen Fläche 2 hergestellt worden ist. Der Bearbeitungszustand des Substrats 1 entspricht somit weitgehend dem der Fig. 1B.

Fig. 3B zeigt das Ergebnis des nachfolgenden Schritts des Abscheidens einer Aufdampfglasschicht 71 auf die mit der ersten Beschichtung 31 versehene Oberfläche.

Die Schicht 71 wird daraufhin wieder durch Abschleifen und Planarisieren der beschichteten Fläche des Substrats 1 in den mit der Schicht 31 beschichteten Bereichen abgetragen und die dabei freigelegte Schicht 31 entfernt, so daß eine positiv strukturierte Aufdampfglasschicht 71 mit Strukturen 91 stehenbleibt. Dieser Bearbeitungszustand ist in Fig. 3C dargestellt.

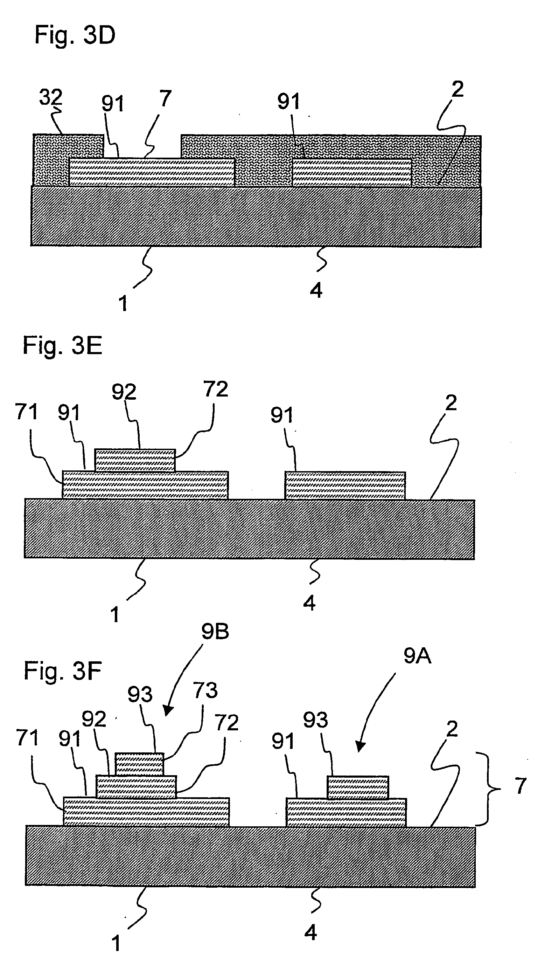

Um weitere Lagen einer mehrlagigen Beschichtung aufzubringen, wird, wie Fig. 3D zeigt, auf der so beschichteten Oberfläche eine weitere erste strukturierte Beschichtung 32 hergestellt. Hier befinden sich, wie anhand von Fig. 3E gezeigt ist, die negativen Strukturen 52 der weiteren ersten Beschichtung 32 auf den Strukturen 91 der strukturierten Aufdampfglasschicht 71. Daraufhin wird noch eine weitere Aufdampfglasschicht 72 aufgebracht, die Schicht 32 durch Abschleifen der Schicht 72 daraufhin freigelegt und die Schicht 32 anschließend entfernt.

Das mehrlagige Aufbringen von Aufdampfglasschichten kann vorteilhaft gemäß den anhand der Fig. 2A und 2B dargestellten Verfahrensschritte realisiert werden.

Diese Verfahrensschritte können gegebenenfalls noch mehrmals wiederholt werden. Fig. 3F zeigt das Substrat 1 nach dem Aufbringen noch einer weiteren Aufdampfglasschicht 73 mit Strukturen 92. Die mehreren Lagen 71, 72 und 73 bilden dabei als Ganzes wieder eine strukturierte Aufdampfglas-Beschichtung 7 mit Strukturen 9A und 9B. Diese Strukturen 9A und 9B können dabei auch nach Bedarf so hergestellt werden, daß einzelne Strukturen nicht Aufdampfglas-Material jeder Beschichtung der einzelnen Lagen 71, 72, 73 aufweisen.

Die Lagen können außerdem auch unterschiedliche Zusammensetzungen.und Schichtdicken aufweisen. Auch können andere Materialien, die beispielsweise nicht glasartig sind, mit Aufdampfglas-Lagen kombiniert werden. Beispielsweise können strukturierte Lagen aufgebracht werden, die etwa Metall, Kunststoff oder halbleitende Stoffe umfassen.

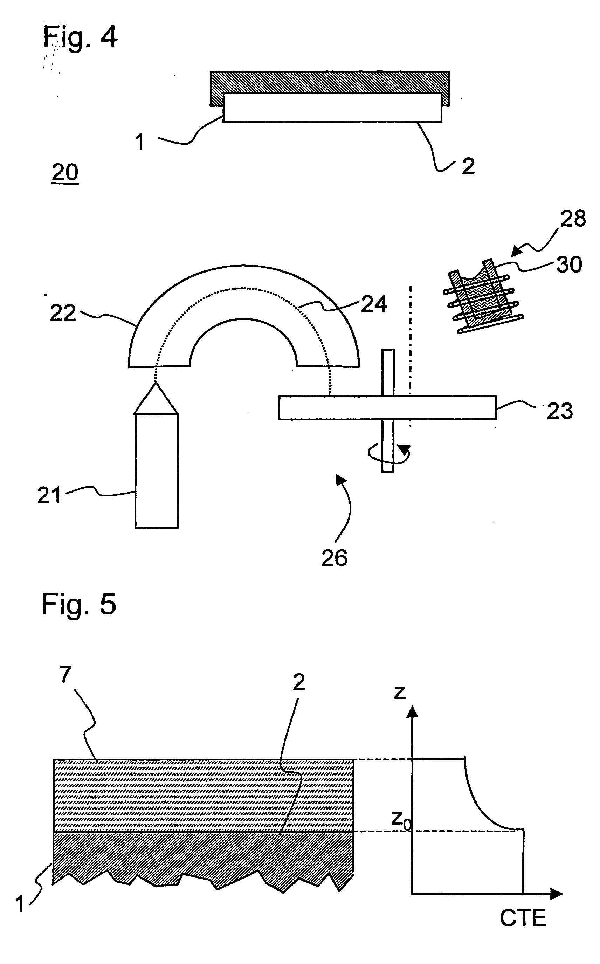

Fig. 4 zeigt eine schematische Ansicht einer als Ganzes mit dem Bezugszeichen 20 bezeichneten Aufdampfvorrichtung zur Durchführung des erfindungsgemäßen Verfahrens. Die Vorrichtung 20 umfaßt dabei speziell einen Elektronenstrahlverdampfer 26.

Der Elektronenstrahlverdampfer 26 weist einen Elektronenstrahlerzeuger 21, eine Strahlumlenkeinrichtung 22 und einen Glastarget 23 auf, das im Betrieb von einem von dem Elektronenstrahlerzeuger 21 emittierten Elektronenstrahl 24 getroffen wird.

Ein zu beschichtendes Substrat 1 mit metallischer Fläche wird in der Vorrichtung so angeordnet, daß die zu beschichtende metallische Fläche einem Glastarget 23 zugewandt ist.

An der Auftreffstelle des Elektronenstrahls verdampft das Glas und schlägt sich auf den gegenüber dem Auftreffpunkt des Elektronenstrahls auf dem Target exponierten Teilen der Oberfläche des Substrats 1 nieder.

Um das Glas des Targets 23 möglichst gleichmäßig verdampfen zu lassen, wird das Target 23 gedreht. Zusätzlich kann der Strahl 24 beispielsweise in radialer Richtung des Targets 23 gewobbelt werden.

Während des Aufdampfvorganges wird der Druck in der Vorrichtung 20 während des Beschichtens auf 10⁻⁴ mbar oder niedriger gehalten. Dies hat sich als günstig erwiesen, um dichte Aufdampfglasschichten mit geringer Defektdichte herzustellen.

Während des Aufdampfens kann das Substrat auch mittels einer geeigneten Einrichtung leicht, beispielsweise auf etwa 100 °C erwärmt werden, was bei vielen Substratmaterialien nach dem Bedampfen auftretende Temperaturspannungen vermeidet oder verringert.

Eine weitere Ausführungsform der Vorrichtung sieht ferner eine in Fig. 4 nicht dargestellte Einrichtung zur Bewegung des Substrats gegenüber der Beschichtungsquelle, beziehungsweise dem Elektronenstrahlverdampfer 26 vor, um beispielsweise die Homogenität der Aufdampfglasschicht zu erhöhen oder nicht planare Substrate abschattungsfrei zu beschichten.

Die Aufdampfvorrichtung 20 kann zusätzlich noch eine Plasmaquelle zur Erzeugung eine Ionenstrahls umfassen, welcher im Betrieb in Richtung auf die zu beschichtende metallische Fläche des Substrats gerichtet ist, um das Substrat mittels Plasma-Ionen-unterstütztem Aufdampfens (PIAD) mit einer Glasschicht zu beschichten.

Die Vorrichtung 20 kann auch noch mit einer oder mehreren weiteren Quellen zur Coverdampfung von Zusatzstoffen oder anderen Aufdampfgläsern ausgestattet sein. Fig. 4 zeigt dazu beispielhaft eine Zusatzquelle 28. Diese kann beispielsweise ebenfalls ein Elektronenstrahlverdampfer sein oder auch, wie in Fig. 4 angedeutet einen elektronenstoß-beheizten Tiegel 30 umfassen, der mit dem Aufdampf-Material befüllt wird.

Das aus dieser Quelle 28 coverdampfte Material kann verwendet werden, um die Zusammensetzung oder Stöchiometrie der Aufdampfglasschicht zu beeinflusssen. Insbesondere kann die Aufdampf- oder Abscheiderate der Quelle 28 während des Beschichtens relativ zur Abscheiderate des Elektronenstrahlverdampfers 26 geändert werden, so daß sich eine entlang einer Richtung senkrecht zur beschichteten metallischen Fläche 2 variierende Zusammensetzung der Aufdampfglasschicht ergibt.

Ein Beispiel eines derartigen Erzeugnisses mit einem Substrat 1 mit beschichteter metallischer Fläche 2 ist in Fig. 5 dargestellt. Auf der Fläche 2 des Substrats 1 ist erfindungsgemäß wieder eine Aufdampfglasschicht 7 aufgebracht worden. Dabei wurde ein Zusatzstoff aus einer weiteren Quelle coverdampft und die Abscheiderate, beziehungsweise der Fluß dieser Quelle während des Aufdampfens variiert. Der Zusatzstoff ist so gewählt, daß er den Temperaturausdehnungskoeffizienten der Aufdampfglasschicht beeinflußt.

Der neben der schematischen Querschittdarstellung des beschichteten Substrats gezeigte Graph stellt den Temperaturausdehnungskoeffizienten CTE als Funktion einer Richtung z senkrecht zur Fläche 2 dar. Der Fluß der weiteren Quelle wurde so gewählt und zeitlich während des Aufdampfens so variiert, daß der Temperaturausdehnungskoeffizient der Aufdampfglasschicht und des Materials der metallischen Fläche an der Position z₀ an der Oberfläche des Substrats 1 weitgehend übereinstimmen. Auf diese Weise kann eine gute dilathermische Anpassung der Aufdampfglasschicht an die metallische Fläche erreicht werden.

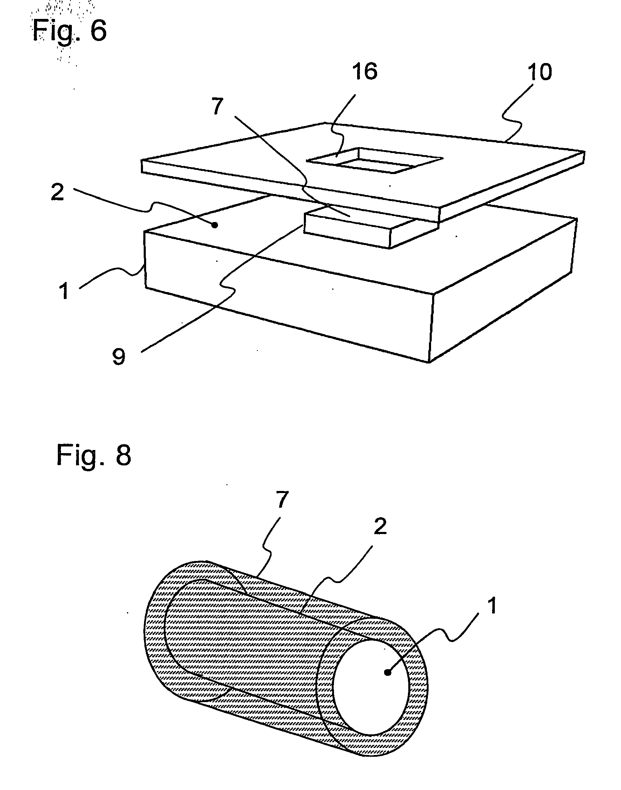

Fig. 6 zeigt in schematischer Ansicht eine Anordnung zur Durchführung einer weiteren Ausführungsform eines erfindungsgemäßen Verfahrens zur strukturierten Beschichtung mit einer Aufdampfglasschicht. Gemäß dieser Ausführungsform des Verfahrens wird eine Maske 10 zwischen der Fläche 2 des zu beschichtenden Substrats 1 und der in Fig. 6 nicht dargestellten Quelle angeordnet. Die Maske 10 weist Öffnungen 16 oder Aussparungen entsprechend der vorgesehenen Form und Position der Strukturen 9 der Aufdampfglasschicht 7 auf, von denen beispielhaft eine Öffnung dargestellt ist.

Um gut definierte Strukturen 9 zu erhalten, ist es vorteilhaft, wenn die Maske 10 möglichst nahe zur Fläche 2 des Substrats 1 angeordnet wird. Das Beschichten mit der Aufdampfglasschicht erfolgt dann durch Aufdampfen auf die Fläche 2 durch die Maske 10.

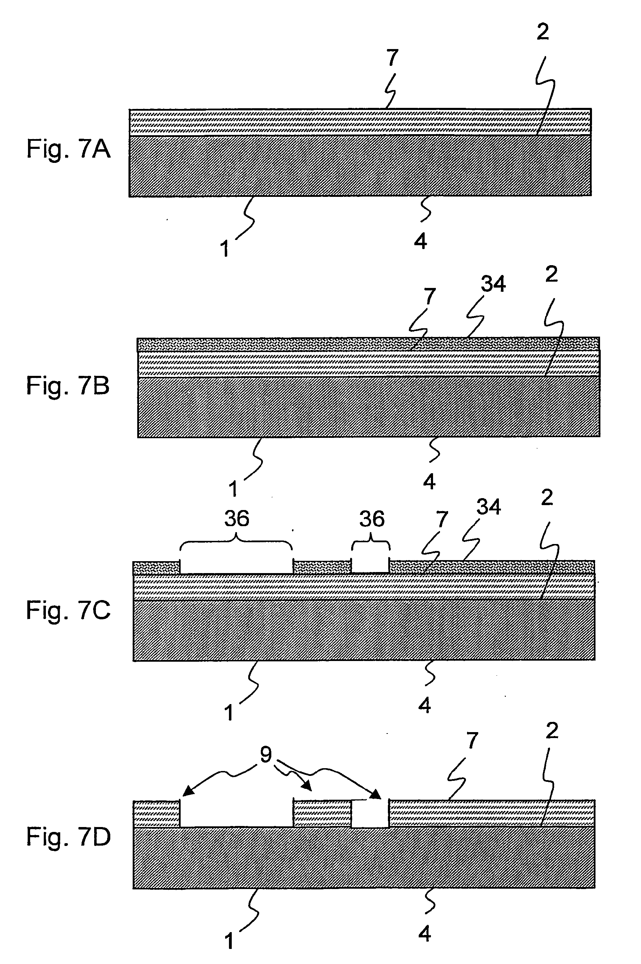

Im folgenden wird auf die Fig. 7A bis 7D Bezug genommen, die anhand von Querschnittanschichten Verfahrensschritte gemäß noch einer Ausführungsform zur Herstellung einer strukturierten Aufdampfglasschicht zeigen.

Dieses Verfahren basiert darauf, die metallische Fläche des Substrats zunächst mit einer homogenen, nicht strukturierten Aufdampfglasschicht zu beschichten und diese dann nachträglich zu strukturieren.

Dementsprechend wird zunächst, wie in Fig. 7A gezeigt, das Substrat 1 auf der metallischen Fläche 2 mit einer Aufdampfglasschicht 7 beschichtet. Anschließend wird, wie in Fig. 7B dargestellt, auf die Aufdampfglasschicht 7 eine photostrukturierbare Schicht 34, beispielsweise ein geeigneter Photolack aufgetragen.

Die Schicht 34 wird dann in einem weiteren Verfahrensschritt photolithographisch strukturiert, so daß, wie Fig. 7C zeigt, Bereiche 36 der darunterliegenden Aufdampfglasschicht 7 freigelegt werden.

Schließlich kann ein geeignetes Ätzmittel angewendet werden, welches nur die Aufdampfglasschicht angreift. Durch die abdeckende, strukturierte Schicht 36 wird demgemäß die darunterliegende Aufdampfglasschicht in den freigelegten Bereichen 36 lokal geätzt. Dabei fungiert die metallische Fläche 2 außerdem als Ätzstopp.

Schließlich kann die photostrukturierte Schicht 36 durch Anwendung eines geeigneten Löse- oder Ätzmittels entfernt werden, so daß ein Erzeugnis mit einem Substrat 1 mit metallischer Fläche 2 und strukturierter, darauf aufgebrachter Aufdampfglasschicht 7 mit Strukturen 9 erhalten wird. Das Erzeugnis, beziehungsweise das beschichtete Substrat ist in Fig. 7D dargestellt.

Mit dem erfindungsgemäßen Verfahren können selbstverständlich auch nicht planare Substrate, beziehungsweise Substrate mit nicht planarer metallischer Fläche mit einer Aufdampfglasschicht beschichtet werden.

Ein solches Ausführungsbeispiel ist in Fig. 8 gezeigt. Das Substrat 1 der in Fig. 8 dargestellten Ausführungsform ist beispielhaft von zylindrischer Gestalt, wobei die mit der Aufdampfglasschicht 7 beschichtete metallische Fläche 2 die Zylindermantelfläche des Substrats 1 bildet. Die Aufdampfglasschicht 7 bedeckt dabei die gesamte zylindrische Fläche 2. Eine derartige Beschichtung kann beispielsweise hergestellt werden, indem das Substrat während des Beschichtens gegenüber der Beschichtungsquelle, wie beispielsweise dem in Fig. 4 gezeigten Elektronenstrahlverdampfer 26 bewegt wird. Im speziellen kann ein zylindrisches Substrat 1 auf seiner Zylindermantelfläche durch Rotation um seine Zylinderachse mit einer wie in Fig. 8 gezeigten geschlossenen Aufdamfglasschicht 7 beschichtet werden.

Es ist dem Fachmann ersichtlich, daß die vorstehend beschriebenen Ausführungsformen beispielhaft zu verstehen sind, und die Erfindung nicht auf diese beschränkt ist, sondern in vielfältiger Weise variiert werden kann, ohne den Rahmen der durch die Patentansprüche definierten Erfindung zu verlassen.

## Patentansprüche

1. Verfahren zur Herstellung eines beschichteten Substrats, welches zumindest eine metallische Fläche aufweist,
wobei
das Aufdampfglas strukturiert auf der metallischen Fläche abgeschieden und das Substrat zumindest auf der metallischen Fläche mit einem Aufdampfglas beschichtet wird, **dadurch gekennzeichnet, dass** das Aufdampfglas durch Elektronenstrahlverdampfung aufgedampft wird.

2. Verfahren gemäß Anspruch 1, **gekennzeichnet durch** die Schritte
- Herstellen zumindest einer negativ strukturierten ersten Beschichtung auf der metallischen Fläche,
- Abscheiden einer insbesondere hermetischen Aufdampfglasschicht auf die mit der ersten Beschichtung versehene metallischen Fläche,
- zumindest teilweise Entfernen der ersten Beschichtung und der darauf befindlichen Aufdampfglasschicht.

3. Verfahren nach Anspruch 2, **dadurch gekennzeichnet, daß** der Schritt des Herstellens einer negativ strukturierten ersten Beschichtung auf der metallischen Fläche den Schritt des Freilegens von Bereichen der zumindest einen zu beschichtenden Oberfläche umfaßt.

4. Verfahren nach einem der Ansprüche 2 oder 3, **dadurch gekennzeichnet, daß** der Schritt des Herstellens einer negativ strukturierten ersten Beschichtung den Schritt des Belackens oder Bedruckens, insbesondere des Belackens mittels Spin-Coating und/oder Aufsprühen und/oder der Elektrodeposition sowie Bedruckens mittels Siebdruck- und/oder Tintenstrahldruckverfahren einer ersten Beschichtung umfaßt.

5. Verfahren nach einem der Ansprüche 2 bis 4, **dadurch gekennzeichnet, daß** der Schritt des zumindest teilweise Entfernens der ersten Beschichtung den Schritt des Abhebens von Bereichen der zumindest einen Aufdampfglasschicht umfaßt, welche die erste Beschichtung bedecken.

6. Verfahren gemäß einem der Ansprüche 2 bis 5, **dadurch gekennzeichnet, daß** die Aufdampfglasschicht mit einer Dicke abgeschieden wird, die geringer als die Dicke der ersten Beschichtung ist.

7. Verfahren nach einem der Ansprüche 2 bis 6, **gekennzeichnet durch** den Schritt des zumindest teilweise Freilegens der ersten Beschichtung.

8. Verfahren nach Anspruch 7, **dadurch gekennzeichnet, daß** der Schritt des zumindest teilweise Freilegens der ersten Beschichtung den Schritt des Planarisierens der beschichteten metallischen Fläche umfaßt.

9. Verfahren nach Anspruch 7 oder 8, **dadurch gekennzeichnet, daß** der Schritt des teilweise Freilegens der ersten Beschichtung den Schritt des mechanischen Abtragens, insbesondere mittels Schleifen und/oder Läppen und/oder Polieren umfaßt.

10. Verfahren gemäß einem der vorstehenden Ansprüche, **dadurch gekennzeichnet, daß** das Aufdampfglas durch eine Maske aufgedampft wird.

11. Verfahren gemäß einem der vorstehenden Ansprüche, **dadurch gekennzeichnet, daß** zumindest zwei Aufdampfglasschichten auf dem Substrat abgeschieden werden.

12. Verfahren gemäß einem der vorstehenden Ansprüche, **dadurch gekennzeichnet, daß** zumindest zwei Aufdampfglasschichten mit unterschiedlicher Zusammensetzung aufgebracht werden.

13. Verfahren gemäß einem der vorstehenden Ansprüche, **dadurch gekennzeichnet, daß** die Aufdampfglasschicht mit einer Dicke in einem Bereich von 0,01 µm bis 1 mm aufgebracht wird.

14. Verfahren gemäß einem der vorstehenden Ansprüche, **dadurch gekennzeichnet, daß** während des Aufbringens der Aufdampfglasschicht dessen Zusammensetzung variiert wird.

15. Verfahren gemäß einem der vorstehenden Ansprüche, **dadurch gekennzeichnet, daß** das Beschichten mit einer Aufdampfglasschicht das Abscheiden von Aufdampfmaterial aus zumindest zwei Quellen durch Coverdampfung umfaßt.

16. Verfahren gemäß einem der vorstehenden Ansprüche, **dadurch gekennzeichnet, daß** das Substrat während des Beschichtens mit der Aufdampfglasschicht erwärmt wird.

17. Verfahren gemäß einem der vorstehenden Ansprüche, **dadurch gekennzeichnet, daß** der Druck während des Beschichtens höchstens 10⁻⁴ mbar beträgt.

18. Verfahren gemäß einem der vorstehenden Ansprüche, **dadurch gekennzeichnet, daß** die Aufdampfglasschicht nach dem Beschichten nachträglich strukturiert wird.

19. Verfahren gemäß Anspruch 19, **dadurch gekennzeichnet, daß** die Aufdampfglasschicht nach dem Beschichten nachträglich durch lokales Ätzen strukturiert wird.

20. Verfahren gemäß einem der vorstehenden Ansprüche, **dadurch gekennzeichnet, daß** das Substrat während des Beschichtens gegenüber der Beschichtungsquelle bewegt wird.

21. Verfahren gemäß einem der vorstehenden Ansprüche, **dadurch gekennzeichnet, dass** das Beschichten mit einem Aufdampfglas das Plasma-Ionen-unterstützte Aufdampfen (PIAD) umfasst.

## Claims

1. Process for producing a coated substrate which comprises at least one metallic surface, wherein the vapour-deposition glass is deposited in a structured manner on the metallic surface and the substrate is coated at least on the metallic surface with a vapour-deposition glass, **characterised in that** the vapour-deposition glass is vapour-deposited by means of electron beam evaporation.

2. Process as claimed in claim 1, **characterised by** the steps of
- producing at least one negatively structured first coating on the metallic surface,
- depositing an in particular hermetic vapour-deposition glass layer onto the metallic surface which is provided with the first coating,
- at least partially removing the first coating and the vapour-deposition glass layer located thereon.

3. Process as claimed in claim 2, **characterised in that** the step of producing a negatively structured first coating on the metallic surface comprises the step of exposing regions of the at least one surface which is to be coated.

4. Process as claimed in any one of claims 2 or 3, **characterised in that** the step of producing a negatively structured first coating comprises the step of resist-coating or printing, in particular resist-coating by means of spin-coating and/or spraying on and/or electron-deposition and of printing by means screen printing and/or ink jet printing processes, a first coating.

5. Process as claimed in any one of claims 2 to 4, **characterised in that** the step of at least partially removing the first coating comprises the step of lifting off regions of the at least one vapour-deposition glass layer which cover the first coating.

6. Process as claimed in any one of claims 2 to 5, **characterised in that** the vapour-deposition glass layer is deposited with a thickness which is less than the thickness of the first coating.

7. Process as claimed in any one of claims 2 to 6, **characterised by** the step of at least partially exposing the first coating.

8. Process as claimed in claim 7, **characterised in that** the step of at least partially exposing the first coating comprises the step of planarizing the coated metallic surface.

9. Method as claimed in claim 7 or 8, **characterised in that** the step of at least partially exposing the first coating comprises the step of mechanical removal, in particular by means of grinding and/or lapping and/or polishing.

10. Process as claimed in any one of the preceding claims, **characterised in that** the vapour-deposition glass is vapour-deposited by means of a mask.

11. Process as claimed in any one of the preceding claims, **characterised in that** at least two vapour-deposition glass layers are deposited on the substrate.

12. Process as claimed in any one of the preceding claims, **characterised in that** at least two vapour-deposition glass layers having a different composition are applied.

13. Process as claimed in any one of the preceding claims, **characterised in that** the vapour-deposition glass layer is applied with a thickness in a range from 0.01 µm to 1 mm.

14. Process as claimed in any one of the preceding claims, **characterised in that** during application of the vapour-deposition glass layer, the composition thereof is varied.

15. Process as claimed in any one of the preceding claims, **characterised in that** the procedure of coating with a vapour-deposition glass layer comprises the deposition of vapour-deposition material from at least two sources by means of co-evaporation.

16. Process as claimed in any one of the preceding claims, **characterised in that** the substrate is heated during coating with the vapour-deposition glass layer.

17. Process as claimed in any one of the preceding claims, **characterised in that** the maximum pressure during coating is 10⁻⁴ mbar.

18. Process as claimed in any one of the preceding claims, **characterised in that** the vapour-deposition glass layer is subsequently structured after coating.

19. Process as claimed in claim 19 *[sic],* **characterised in that** after coating the vapour-deposition glass layer is subsequently structured by local etching.

20. Process as claimed in any one of the preceding claims, **characterised in that** during coating the substrate is moved with respect to the coating source.

21. Process as claimed in any one of the preceding claims, **characterised in that** the procedure of coating with a vapour-deposition glass comprises plasma ion assisted deposition (PIAD).

## Revendications

1. Procédé de fabrication d'un substrat revêtu qui comporte au moins une surface métallique, dans lequel le verre de dépôt en phase vapeur est déposé structuré sur la surface métallique et le substrat est revêtu d'un verre de dépôt en phase vapeur au moins sur la surface métallique, **caractérisé en ce que** le verre de dépôt en phase vapeur est déposé en phase vapeur au faisceau électronique.

2. Procédé selon la revendication 1, **caractérisé par** les étapes de :
- fabrication d'au moins un premier revêtement à structure négative sur la surface métallique,
- dépôt d'une couche de verre de dépôt en phase vapeur notamment hermétique sur la surface métallique munie du premier revêtement,
- élimination au moins partielle du premier revêtement et de la couche de verre de dépôt en phase vapeur se trouvant dessus.

3. Procédé selon la revendication 2, **caractérisé en ce que** l'étape de la fabrication d'un premier revêtement à structure négative sur la surface métallique comprend l'étape du dégagement de zones de la au moins une surface à revêtir.

4. Procédé selon l'une des revendications 2 ou 3, **caractérisé en ce que** l'étape de la fabrication d'un premier revêtement à structure négative comprend l'étape du vernissage ou de l'impression, notamment du vernissage par spin-coating et/ou par pulvérisation et/ou par électrodéposition ainsi que de l'impression par un procédé de sérigraphie et/ou d'impression à jet d'encre d'un premier revêtement.

5. Procédé selon l'une des revendications 2 à 4, **caractérisé en ce que** l'étape de l'élimination au moins partielle du premier revêtement comprend l'étape de l'enlèvement de zones de la au moins une couche de verre de dépôt en phase vapeur qui recouvrent le premier revêtement.

6. Procédé selon l'une des revendications 2 à 5, **caractérisé en ce que** la couche de verre de dépôt en phase vapeur est déposée en une épaisseur qui est inférieure à l'épaisseur du premier revêtement.

7. Procédé selon l'une des revendications 2 à 6, **caractérisé par** l'étape du dégagement au moins partiel du premier revêtement.

8. Procédé selon la revendication 7, **caractérisé en ce que** l'étape du dégagement au moins partiel du premier revêtement comprend l'étape de l'applanissement de la surface métallique revêtue.

9. Procédé selon la revendication 7 ou 8,
**caractérisé en ce que** l'étape du dégagement au moins partiel du premier revêtement comprend l'étape de l'enlèvement mécanique, notamment par meulage et/ou rodage et/ou polissage.

10. Procédé selon l'une des revendications précédentes, **caractérisé en ce que** le verre de dépôt en phase vapeur est déposé en phase vapeur à travers un masque.

11. Procédé selon l'une des revendications précédentes, **caractérisé par le fait qu'**au moins deux couches de verre de dépôt en phase vapeur sont déposées sur le substrat.

12. Procédé selon l'une des revendications précédentes, **caractérisé par le fait qu'**au moins deux couches de verre de dépôt en phase vapeur de composition différente sont appliquées.

13. Procédé selon l'une des revendications précédentes, **caractérisé en ce que** la couche de verre de dépôt en phase vapeur est appliquée en une épaisseur comprise entre 0,01 µm et 1 mm.

14. Procédé selon l'une des revendications précédentes, **caractérisé en ce que**, pendant l'application de la couche de verre de dépôt en phase vapeur, la composition de celui-ci est modifiée.

15. Procédé selon l'une des revendications précédentes, **caractérisé en ce que** le revêtement avec une couche de verre de dépôt en phase vapeur comprend le dépôt de matériau de dépôt en phase vapeur provenant d'au moins deux sources par dépôt de couverture.

16. Procédé selon l'une des revendications précédentes, **caractérisé en ce que** le substrat est chauffé pendant le revêtement avec la couche de verre de dépôt en phase vapeur.

17. Procédé selon l'une des revendications précédentes, **caractérisé en ce que** la pression pendant le revêtement est égale au maximum à 10⁻⁴ mbar.

18. Procédé selon l'une des revendications précédentes, **caractérisé en ce que** la couche de verre de dépôt en phase vapeur est structurée ultérieurement, après le revêtement.

19. Procédé selon la revendication 19, **caractérisé en ce que** la couche de verre de dépôt en phase vapeur est structurée ultérieurement, après le revêtement, par gravure locale.

20. Procédé selon l'une des revendications précédentes, **caractérisé en ce que**, pendant le revêtement, le substrat est déplacé par rapport à la source de revêtement.

21. Procédé selon l'une des revendications précédentes, **caractérisé en ce que** le revêtement avec un verre de dépôt en phase vapeur comprend le dépôt en phase vapeur assisté par ions de plasma (PIAD).
